# EUROPÄISCHE PATENTSCHRIFT

(11) **EP 0 554 267 B1**
(45) Veröffentlichungstag und Bekanntmachung des Hinweises auf die Patenterteilung: **14.12.1994**
(21) Anmeldenummer: 91916585.2
(22) Anmeldetag: 26.09.1991
(51) Int. Cl.: G01P 3/481, B60T 8/66, H03K 5/08

(54) **VERFAHREN UND SCHALTUNGSANORDNUNG ZUR AUFBEREITUNG DES AUSGANGSSIGNALS EINES DREHZAHLSENSORS**
METHOD AND CIRCUIT ARRANGEMENT FOR PREPARING THE OUTPUT SIGNAL OF A REVOLUTION SPEED SENSOR
PROCEDE ET CIRCUIT DE PREPARATION DU SIGNAL DE SORTIE DE CAPTEUR DE VITESSE DE ROTATION

(30) Priorität: 24.10.1990 DE 4033740
(43) Veröffentlichungstag der Anmeldung: 11.08.1993
(73) Patentinhaber: ITT Automotive Europe GmbH, 60488 Frankfurt (DE)
(72) Erfinder: LORECK, Heinz, D-6270 Idstein 2 (DE); ZYDEK, Michael, D-6230 Frankfurt/Main 80 (DE); FEY, Wolfgang, D-6501 Wörrstadt (DE)
(86) Internationale Anmeldenummer: EP9101843
(87) Internationale Veröffentlichungsnummer: WO9208137

(56) Entgegenhaltungen:
- DE-A- 3 714 271
- DE-B- 2 235 056
- US-A- 4 575 677

## Beschreibung

Die Erfindung bezieht sich auf ein Verfahren zur Aufbereitung des Ausgangssignals eines Drehzahlsensors, z.B. des Radsensors eines Kraftfahrzeuges, dessen Frequenz zur Bestimmung der Radgeschwindigkeit ausgewertet wird, dessen Amplitude jedoch ebenfalls von der Radgeschwindigkeit abhängig ist, mit Hilfe einer Triggerschaltung, deren "Hysterese" oder Triggerschwellen steuerbar sind, mit Hilfe von Schaltkreisen zur Ermittlung eines Kopplungsfaktors, der multipliziert mit der der Drehzahl entsprechenden Frequenz des Sensorsignals die Amplitude des Sensor-Ausgangssignals ergibt, und mit Hilfe von Schaltkreisen zur Einstellung der "Hysterese" der Triggerschaltung in Abhängigkeit von dem Kopplungsfaktor. Eine Schaltungsanordnung zur Durchführung des Verfahrens gehört ebenfalls zur Erfindung.

Die Drehzahl eines Rades oder einer Welle läßt sich bekanntlich mit Hilfe einer Zahnscheibe, die mit dem Rad oder mit der Welle umläuft, und eines feststehenden induktiven Meßwertaufnehmers ermitteln. Die rotierende Zahnscheibe induziert hierbei in der Spule des Meßwertaufnehmers eine Wechselspannung, deren Frequenz von der Zähnezahl und der Drehbewegung abhängig ist, und die daher zur Ermittlung der Drehbewegung abgegriffen sowie ausgewertet werden kann. Es sind jedoch nicht nur die Frequenz, sondern auch die Amplitude des Ausgangssignals, das der Meßwertaufnehmer bzw. Radsensor abgibt, von der Drehbewegung abhängig. Bei langsamen Drehbewegungen ist die Amplitude so gering, daß die Trennung des Nutzsignals von den unvermeidlichen Störungen Schwierigkeiten bereitet. Da die Signalamplitude sehr stark von dem Luftspalt zwischen der Zahnscheibe und dem Meßwertaufnehmer abhängt und Fertigungstoleranzen eingeräumt werden müssen, kann die Amplitude des Sensor-Ausgangssignals bei gleicher Drehbewegung sehr unterschiedliche Werte annehmen. Man war daher bisher gezwungen, sehr enge Fertigungstoleranzen vorzuschreiben, den Luftspalt nach der Montage und bei der Wartung des Fahrzeugs nachzustellen und durch entsprechende Auslegung der Sensorsignal-Aufbereitungsschaltung die Auswirkungen der starken Abhängigkeit der Signal-Amplitude von der Drehzahl auszugleichen.

Nach der älteren Patentanmeldung DE 39 36 831-A1 wurde bereits vorgeschlagen, die "Hysterese" bzw. die Schwellwerte der Triggerschaltung, der das Sensorausgangssignal zugeführt wird, in Abhängigkeit von dem tatsächlichen Kopplungsfaktor einzustellen. Hierzu wurde diese Schaltungsanordnung zur Aufbereitung des Sensorausgangssignals mit Schaltkreisen ausgerüstet, die aus der Signalfrequenz, die der Drehzahl proportional ist, und aus der Signalspannung den Kopplungsfaktor ermitteln und die nach "Bewertung" des gemessenen Faktors unter Berücksichtigung der Fahrzeuggeschwindigkeit die Hysterese der Triggerschaltung beeinflußten. Dabei wurde die Messung des Kopplungsfaktors bei höherer Geschwindigkeit als "sicherer" bewertet, weshalb der Einfluß der Messung auf die Hysterese-Nachführung bei höherer Radgeschwindigkeit stärker ausgelegt war als bei geringerer Radgeschwindigkeit.

Der vorliegenden Erfindung liegt die Aufgabe zugrunde, ein besonders einfaches und zuverlässiges Verfahren zur Einstellung der Hysterese der Triggerschaltung anzugeben.

Zur Lösung dieser Aufgabe wird das Verfahren der eingangs genannten Art derart ausgebildet, daß zur Ermittlung des Kopplungsfaktors und zur Einstellung der Hysterese der Triggerschaltung Amplituden-Schwellwerte die positive oder negative Abweichungen der Amplitude des Drehzahlsensor-Ausgangssignals (U_{S}) von einem durch Vorspannung festgelegten Nullpunkt oder Arbeitspunkt definieren, für das Ausgangssignal des Drehzahlsensors vorgegeben werden und daß beim Anfahren des Fahrzeugs aus der die Radgeschwindigkeit wiedergebenden Frequenz des Sensorsignals zu dem Zeitpunkt an den innerhalb einer Periode erstmalig beide Schwellwerte erreicht oder überschritten werden, der Kopplungsfaktor bestimmt wird.

Erfindungsgemäß werden also für das Ausgangssignal des Drehzahlsensors Amplituden-Schwellwerte bzw. ein positiver und ein negativer Schwellwert festgelegt und die "Hysterese" der Triggerschaltung eingestellt, sobald beim Anfahren des Fahrzeugs das Ausgangssignal des Sensors diese Triggerschwellen erreicht. Da das Wechselsignal am Ausgang des Drehzahlsensors, z.B. durch Variation des Luftspalts infolge einer Exzentrizität oder durch eine Störung, verzerrt sein kann, wird die "Hysterese"-Einstellung erst hervorgenommen, wenn während einer Periode sowohl der positive als auch negative Schwellwert erreicht bzw. überschritten werden.

Eine Schaltungsanordnung zur Durchführung des Verfahrens nach der Erfindung besteht darin, daß diese eine Schaltung zur Erzeugung eines Signals zu dem Zeitpunkt, an dem innerhalb einer Periode erstmalig beide Amplituden-Schwellwerte erreicht oder überschritten werden, aufweist und ein Rechenwerk oder einen Microprozessor enthält, der zur Errechnung des Koppelfaktors aus der Radgeschwindigkeit zu dem Zeitpunkt des Erreichens der Amplituden-Schwellwerte und zur Abgabe eines Signals zur Einstellung der Hysterese in Abhängigkeit von dem Kopplungsfaktor ausgebildet ist.

Nach einem vorteilhaften Ausführungsbeispiel der Erfindung kann das Verfahren derart ausgelegt sein, daß die Hysterese-Einstellung bei jedem Anfahren des Fahrzeugs wiederholt wird. Andererseits könnte es jedoch auch zweckmäßig sein und genügen, die Hysterese-Einstellung durch regelmäßig wiederkehrende Vorgänge, z.B. bei jedem Starten des Kraftfahrzeug-Motors und anschließendem Anfahren des Fahrzeugs, zu initiieren.

Weitere Details der Erfindung gehen aus der beigefügten Schaltungsanordnung und aus den Diagrammen zur Veranschaulichung der Arbeitsweise hervor.

Es zeigen:
- Fig. 1: eine Ausführungsart einer Schaltungsanordnung nach der Erfindung und
- Fig.2: in Diagrammen den Signalverlauf an den angegebenen Meßpunkten der Schaltungsanordnung nach Fig.1.

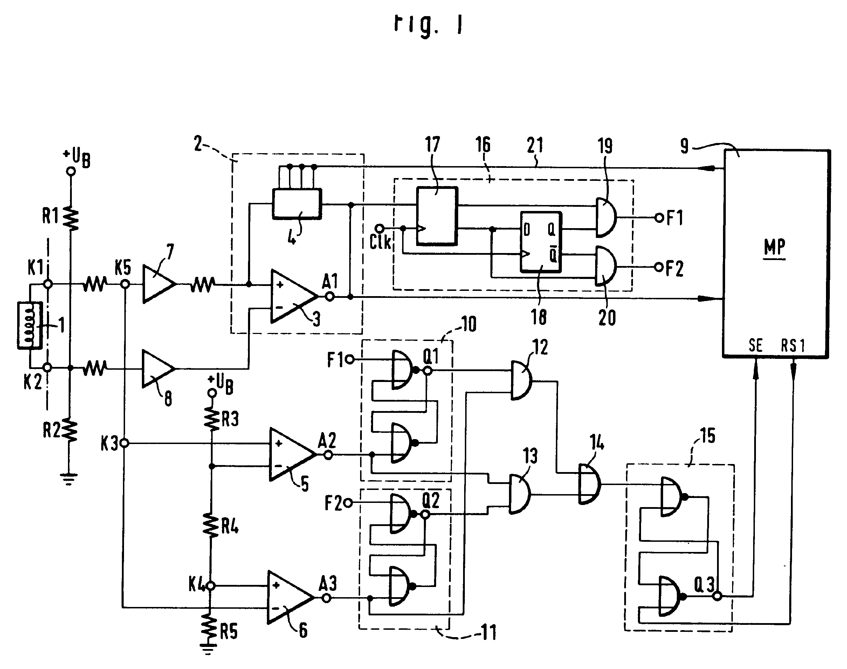

Die in Fig.1 wiedergegebene Schaltungsanordnung dient zur Aufbereitung des Ausgangssignals eines Radsensors 1. Solche Radsensoren werden beispielsweise in Kraftfahrzeuge eingebaut und sind Bestandteile eines Antiblockiersystems, einer Antriebsschlupfregelung oder liefern Informationen für eine elektronische Fahrwerkregelung.

Das Ausgangssignal des Sensors 1 wird einer Triggerschaltung 2, die einen Komparator 3 mit einem steuerbaren Rückkopplungsschaltkreis 4 enthält, zugeführt. Mit Hilfe des Rückkopplungsschaltkreises 4 werden die Triggerschwellen bzw. die Hysterese der Triggerschaltung 2 eingestellt.

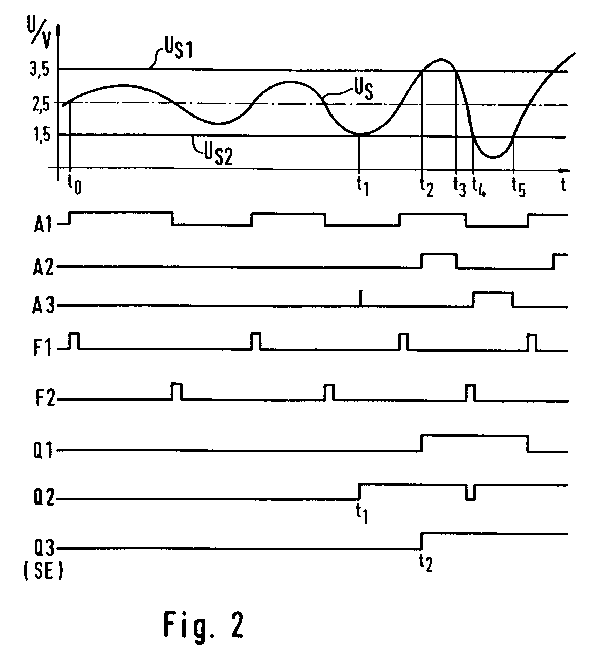

Der Arbeitspunkt oder Nullpunkt des Sensors 1 wird im vorliegenden Fall durch einen Spannungsteiler R1, R2, der an einer stabilisierten Gleichspannung +U_{B} liegt, festgelegt. Das von den Klemmen K1, K2 abgreifbare Ausgangssignal des Radsensors 1 ist in der Praxis eine annähernd symmetrisch um diesen Nullpunkt schwingende Sinusspannung. Ein weiterer Spannungsteiler R3,R4,R5, der ebenfalls an der Spannungsquelle +U_{B} angeschlossen ist, definiert einen positiven und einen negativen Schwellwert U_{S1}, U_{S2} - siehe Fig.2 -, dessen Überschreitung bzw. Unterschreitung mit Hilfe von Komparatoren 5,6 festgestellt und signalisiert wird. In einem Ausführungsbeispiel lag das Potential an der Klemme K2 auf +2,5 V, die U_{S1} bzw. U_{S2} an der Klemme K3 auf +3,5 V , an K4 auf 1,5 V. Folglich mußte die Amplitude des Ausgangssignals des Radsensors bezogen auf dem Arbeitspunkt +1 V und -1 V erreichen, um ein Ausgangssignal an den Komparatoren 5, 6 bzw eine Ausgangssignaländerung hervorzurufen.

Mit 7 und 8 sind Trennstufen oder Impedanzwandler bezeichnet, die eingefügt sind, um Rückwirkungen auf den Ausgang des Sensors 1 durch die Hystereseeinstellung zu vermeiden.

Zwischen den Ausgängen A2 und A3 der Komparatoren 5 bzw. 6 und einem Mikroprozessor 9 sind einige Kippstufen und Gatter eingefügt, über die dem Mikroprozessor 9 "Schwellenerkennung" (SE) signalisiert wird, sobald der positive und negative Schwellwert, auf den die Komparatoren 5,6 eingestellt sind, während einer Periode erreicht oder überschritten sind.

Die Ausgänge A2 und A3 der Komparatoren 5 bzw. 6 führen jeweils zu einem Flip-Flop 10 bzw. 11, die gesetzt werden bzw. deren Ausgänge Q1 bzw. Q2 Signal führen,wenn ein Eingangssignal F1 bzw. F2 vorhanden ist und beim Anfahren des Fahrzeugs bzw. beim Ansteigen der Ausgangsspannung U_{S} des Radsensors 1 der entsprechende positive oder negative Schwellwert U_{S1}, U_{S2} erreicht oder überschritten wird. Über UND-Gatter 12 oder 13 und über ein ODER-Gatter 14 wird sichergestellt, daß nur dann ein Signal weitergeleitet wird, wenn der positive und negative Schwellwert während einer Periode erreicht oder Überschritten wurde. Über einen Ausgang Q3 eines weiteren Flip-Flops 15, das über den Ausgang RS1 des Mikroprozessors 9 zurückgesetzt werden kann, wird die Schwellenerkennung SE signalisiert.

Die Ansteuersignale F1, F2 der Flip-Flop-Stufen 10,11 werden mit Hilfe eines Schaltkreises 16 erzeugt, der im wesentlichen aus zwei flankengesteuerten Flip-Flops 17,18 und zwei UND-Gattern 19,20 besteht. Wie Fig. 2 veranschaulicht, wird das Signal F1 bei jedem Nulldurchgang und positiver Flanke des Radsensor-Ausgangssignals U_{S} hervorgerufen, das Signal F2 bei jedem Nulldurchgang und negativer Flanke des Ausgangssignals U_{S}. Diese beiden Signale F1,F2 bewirken das Rücksetzen der Flip-Flops 10,11, so daß das Flip-Flop 15 nur gesetzt wird, wenn innerhalb einer Periode der negative und der positive Schwellwert erreicht oder überschitten werden. Am Ausgang Q1 des Flip-Flops 10 erscheint folglich ein Signal, sobald der positive Schwellwert U_{S1} erreicht oder überschritten wird. Das Flip-Flop 10 wird mit dem Signal F1 wieder zurückgesetzt. Die gleiche Funktionsweise gilt für das Flip-Flop 11, das beim Erreichen oder Überschreiten der Schwelle U_{S2} gesetzt und durch das Signal F2 zurückgesetzt wird. Am Ausgang Q3 des Flip-Flops 15 erscheint folglich ein Signal, sobald der positive Schwellwert U_{S1} erreicht oder überschritten ist, unter der Bedingung, daß unmittelbar zuvor der negative Schwellwert U_{S2} erreicht war; die Überschreitung der positiven Schaltschwelle U_{S1} nach unmittelbar vorausgegangenem Erreichen der negativen Schaltschwelle U_{S2} findet nach Fig.2 zum Zeitpunkt t₂ statt.

Die negative Schaltschwelle U_{S2} wird nach Fig. 2 zum Zeitpunkt t₁ erreicht. Da jedoch zuvor die Sensor-Ausgangsspannung U_{S} unter dem (positiven) Schwellwert U_{S1} lag, führt das Erreichen des Schwellwertes U_{S2} noch nicht zum Kippen des Flip-Flops 15 bzw. zum Entstehen eines Ausgangssignals Q3, welches mit dem Signal "Schwellenerkennung" (SE) am Mikroprozessor 9 identisch ist.

Im übrigen ist der Signalverlauf an den Ausgängen A1, A2, A3 der Komparatoren 3,5,6, der durch die Schaltung 16 erzeugten Rückstellsignalen F1 und F2 und der Flip-Flop-Ausgangssignale Q1, Q2, Q3 (SE) für einen Anfahrvorgang eines Fahrzeugs dargestellt. Der Spannungsverlauf U_{S} am Ausgang des Radsensors 1 bzw. an der Klemme K5, für den diese Signalverläufe gelten, ist ebenfalls in Fig. 2 dargestellt. Für den Spannungsverlauf U_{S} und für die Signalverläufe an den in Fig.2 genannten Punkten gilt das gleiche Zeitraster.

Die Rückstellung des Flip-Flops 15 durch das von dem Mikroprozessor 9 erzeugte Rückstellsignal RS1 erfolgt - je nach Ausführungsart der Erfindung - vor jedem Anfahren des Fahrzeugs oder bei regelmäßig wiederkehrenden Ereignissen, z.B. bei jedem Anlassen des Fahrzeugs.

Bei der Darstellung des Ausgangssignals A1 des Komparators 3 nach Fig. 2 wurde die Schalthysterese vernachlässigt. Während des Anfahrvorgangs wird zweckmäßigerweise eine Grundhysterese von z.B. 100 mV vorgegeben bzw. durch den Mikroprozessor 9 eingestellt. Nach dem Errechnen des Kopplungsfaktors aus den Schaltschwellen bzw. dem Erreichen der Schaltschwellen und aus der zu diesem Zeitpunkt erreichten Fahrzeug- oder Radgeschwindigkeit durch den Mikroprozessor 9 wird mit Hilfe des Schaltkreises 4, zu dem die Leitung 21 führt, die "Hysterese" auf den geeigneten Wert eingestellt. In einem Ausführungsbeispiel der Erfindung wurde der Komparator 3 und der Schaltkreis 4 in Form eines Bauelementes mit digital einstellbarer Hysterese ausgebildet. Die vier Leitungen am Eingang des Rückkopplungsschaltkreises 4 nach Fig. 1 stellen symbolisch dar, daß das Rückkopplungssignal durch eine vierstellige binäre Zahl übertragen wird; die Hysterese läßt sich folglich in diesem Fall auf maximal 16 unterschiedliche Werte einstellen.

Die Arbeitsweise der erfindungsgemäßen Schaltungsanordnung geht bereits aus der vorgegangenen Beschreibung hervor. Die "Hysterese" ist zunächst auf einen sehr geringen Grundwert von z.B. 100 mV eingestellt. Nach dem Erreichen oder Überschreiten des positiven und des negativen Schwellwertes während eines Anfahrvorganges, wobei beide Schwellwerte unmittelbar aufeinanderfolgend erreicht werden müssen, errechnet der Mikroprozessor den tatsächlichen Kopplungsfaktor und stellt je nach Ergebnis dieser Berechnung die "Hysterese" auf den geeigneten Wert ein. Zu bestimmten Zeitpunkten wird das Schwellenerkennungssignal von dem Mikroprozessor über den Ausgang RS1 wieder gelöscht und eine erneute Berechnung der Hysterese bzw. der Triggerschwellen vorgenommen.

## Patentansprüche

1. Verfahren zur Aufbereitung des Ausgangssignals eines Drehzahlsensors, z.B. des Radsensors eines Kraftfahrzeuges, dessen Frequenz zur Bestimmung der Radgeschwindigkeit ausgewertet wird, dessen Amplitude jedoch ebenfalls von der Radgeschwindigkeit abhängig ist, mit Hilfe einer Triggerschaltung, deren "Hysterese" oder Triggerschwellen steuerbar sind, mit Hilfe von Schaltkreisen zur Ermittlung eines Kopplungsfaktors, der multipliziert mit der der Drehzahl entsprechenden Frequenz des Sensorsignals die Amplitude des Sensor-Ausgangssignals ergibt, und mit Hilfe von Schaltkreisen zur Einstellung der "Hysterese" der Triggerschaltung in Abhängigkeit von dem Kopplungsfaktor, dadurch **gekennzeichnet**, daß zur Ermittlung des Kopplungsfaktors und zur Einstellung der Hysterese der Triggerschaltung Amplituden-Schwellwerte (U_{S1},U_{S2}), die positive (U_{S1}) oder negative (U_{S2}) Abweichungen der Amplitude des Drehzahlsensor-Ausgangssignals (U_{S}) von einem durch Vorspannung festgelegten Nullpunkt oder Arbeitspunkt definieren, für das Ausgangssignal (U_{S}) des Drehzahlsensors (1) vorgegeben werden und daß beim Anfahren des Fahrzeugs aus der die Radgeschwindigkeit wiedergebenden Frequenz des Sensorsignals zu dem Zeitpunkt (t₂), an den innerhalb einer Periode erstmalig beide Schwellwerte (U_{S1},U_{S2}) erreicht oder überschritten werden, der Kopplungsfaktor bestimmt wird.

2. Verfahren nach Anspruch 1, dadurch **gekennzeichnet**, daß bei jedem Anfahren des Fahrzeugs die Hysterese-Einstellung wiederholt wird.

3. Verfahren nach Anspruch 1 oder 2, dadurch **gekennzeichnet,** daß durch regelmäßig wiederkehrende Vorgänge, z.B. bei jedem Starten des Kraftfahrzeugsmotors und anschließendem Anfahren des Fahrzeugs, die Hysterese-Einstellung wiederholt wird.

4. Schaltungsanordnung zur Durchführung des Verfahrens nach Anspruch 1, dadurch **gekennzeichnet**, daß diese eine Schaltung zur Erzeugung eines Signals (SE) zu dem Zeitpunkt (t₂), an dem innerhalb einer Periode erstmalig beide Amplituden-Schwellwerte (U_{S1},U_{S2}) erreicht oder überschritten werden, aufweist und ein Rechenwerk oder einen Microprozessor (9) enthält, der zur Errechnung des Koppelfaktors aus der Radgeschwindigkeit zu dem Zeitpunkt (t₂) des Erreichens der Amplituden-Schwellwerte und zur Abgabe eines Signals zur Einstellung der Hysterese in Abhängigkeit von dem Kopplungsfaktor ausgebildet ist.

## Claims

1. A method of conditioning the output signal of a rotational speed sensor, for example the wheel sensor of an automotive vehicle, the frequency of which is analyzed for determining the wheel speed, the amplitude thereof, however, being equally responsive to the wheel speed, by means of a trigger circuit, the "hysteresis" or trigger thresholds of which are controllable, by means of circuits for determining a coupling factor which, multiplied by the frequency of the sensor signal that corresponds to the rotational speed, forms the amplitude of the sensor output signal, and by means of circuits for adjusting the "hysteresis" of the trigger circuit in response to the coupling factor,
**characterized** in that for determining the coupling factor and for adjusting the hysteresis, the trigger circuit is furnished with predetermined amplitude threshold values (U_{S1}, U_{S2}) for the output signal (U_{S}) of the rotational speed sensor (1), which threshold values define positive (U_{S1}) or negative (U_{S2}) deviations of the amplitude of the output signal (U_{S}) of the rotational speed sensor from a zero point or working point preset by preload, and in that on start-up of the vehicle, the coupling factor is determined from the frequency of the sensor signal representative of the wheel speed at the point in time (t₂) when both threshold values (U_{S1}, U_{S2}) are reached or exceeded within a period for the first time.

2. A method as claimed in claim 1,
**characterized** in that the adjustment of the hysteresis is repeated on every start of the vehicle.

3. A method as claimed in claim 1 or claim 2,
**characterized** in that the hysteresis adjustment is repeated by regularly recurring actions, e.g. whenever the engine of the automotive vehicle is switched on and by subsequent start of the vehicle.

4. A circuit configuration for implementing the method as claimed in claim 1,
**characterized** in that it comprises a circuit for generating a signal (SE) at the point in time (t₂) when both amplitude threshold values (U_{S1}, U_{S2}) are reached or exceeded within a period for the first time, and comprises an arithmetic unit or a microprocessor (9) which is provided to calculate the coupling factor from the wheel speed at the point in time (t₂) the amplitude threshold values are reached and to issue a signal for the adjustment of the hysteresis in dependence on the coupling factor.

## Revendications

1. Procédé d'élaboration du signal de sortie d'un capteur de vitesse de rotation, p.ex. du capteur de roue d'un véhicule, dont la fréquence pour la détermination de la vitesse de la roue est évaluée, mais dont l'amplitude dépend également de la vitesse de la roue, à l'aide d'un déclencheur dont l'"hystérésis" ou les seuils de déclenchement peuvent être commandés, à l'aide de circuits pour déterminer un coefficient de couplage, qui, multiplié par la fréquence du signal de capteur correspondant à la vitesse de rotation, donne l'amplitude du signal de sortie du capteur, et à l'aide de circuits pour le réglage de l'"hystérésis" du déclencheur en fonction du coefficient de couplage, caractérisé en ce que, pour déterminer le coefficient de couplage et pour régler l'hystérésis du déclencheur, on prédéfinit pour le signal de sortie (U_{S}) du capteur de vitesse de rotation (1), des seuils d'amplitude (U_{S1}, U_{S2}) qui définissent des écarts positifs (U_{S1}) ou négatifs (U_{S2}) de l'amplitude du signal de sortie du capteur de vitesse de rotation (U_{S}) par rapport à un point zéro ou point de fonctionnement déterminé par polarisation, et que lorsque le véhicule est mise en marche, on détermine par la fréquence du signal du capteur indiquant la vitesse de rotation de la roue, au moment (t₂) où à l'intérieur d'une période les deux seuils (U_{S1}, U_{S2}) sont atteints ou dépassés pour la première fois, le coefficient de couplage.

2. Procédé selon la revendication 1, caractérisé en ce que le réglage de l'hystérésis est répété à chaque fois que le véhicule se met en marche.

3. Procédé selon l'une quelconque des revendications 1 ou 2, caractérisé en ce que le réglage de l'hystérésis est répété pour des événements répétitifs réguliers, par exemple à chaque démarrage du moteur du véhicule suivi de la mise en marche du véhicule.

4. Circuit pour la mise en oeuvre d'un procédé selon la revendication 1, caractérisé en ce que celui-ci présent un circuit, pour la production d'un signal (SE) au moment (t₂) où sont atteints ou dépassées pour la première fois, durant une période, les deux seuils d'amplitude (U_{S1}, U_{S2}) et comporte une unité de calcul ou un microprocesseur (9), développé pour le calcul du coefficient de couplage à partir de la vitesse de la roue au moment (t₂) où sont atteints les seuils d'amplitude et pour l'émission d'un signal pour le réglage de l'hystérésis en fonction du facteur de couplage.
